(19) Europäisches Patentamt / European Patent Office / Office européen des brevets

(11) **EP 1 559 126 B1**

(12) **EUROPÄISCHE PATENTSCHRIFT**

(45) Veröffentlichungstag und Bekanntmachung des Hinweises auf die Patenterteilung:
**23.05.2007 Patentblatt 2007/21**

(51) Int Cl.:
*H01J 37/05* (2006.01)     *H01J 37/295* (2006.01)
*H01J 49/48* (2006.01)

(21) Anmeldenummer: 03775291.2

(22) Anmeldetag: **04.11.2003**

(86) Internationale Anmeldenummer:
**PCT/EP2003/012283**

(87) Internationale Veröffentlichungsnummer:
**WO 2004/042770 (21.05.2004 Gazette 2004/21)**

(54) **BILDGEBENDER ENERGIEFILTER FüR ELEKTRISCH GELADENE TEILCHEN UND VERWENDUNG DES BILDGEBENDEN ENERGIEFILTERS**

ENERGY FILTER IMAGE GENERATOR FOR ELECTRICALLY CHARGED PARTICLES AND THE USE THEREOF

FILTRE D'ENERGIE GENERATEUR D'IMAGES POUR PARTICULES CHARGEES ELECTRIQUEMENT ET UTILISATION DE CE FILTRE

(84) Benannte Vertragsstaaten:
**DE GB**

(30) Priorität: **04.11.2002 DE 10252129**

(43) Veröffentlichungstag der Anmeldung:
**03.08.2005 Patentblatt 2005/31**

(73) Patentinhaber:
• **Omicron Nano Technology GmbH**
**65232 Taunusstein (DE)**
• **Focus GmbH, Geräte zur Elektronenspektroskopie und Oberflächenanalytik**
**65510 Hünstetten-Görsroth (DE)**

(72) Erfinder:
• **FUNNEMANN, Dietmar**
**65232 Taunusstein (DE)**
• **ESCHER, Matthias**
**65520 Bad Camberg (DE)**

(74) Vertreter: **Fuchs Mehler Weiss & Fritzsche Patentanwälte**
**Söhnleinstrasse 8**
**65201 Wiesbaden (DE)**

(56) Entgegenhaltungen:
WO-A-01/61725         US-A- 5 466 933

• DINNIS A R ET AL: "TIME-OF-FLIGHT ELECTRON SPECTROMETER FOR VOLTAGE MEASUREMENTS ON INTEGRATED CIRCUITS" JOURNAL OF VACUUM SCIENCE AND TECHNOLOGY: PART B, AMERICAN INSTITUTE OF PHYSICS. NEW YORK, US, Bd. 11, Nr. 6, 1. November 1993 (1993-11-01), Seiten 2452-2455, XP000423376 ISSN: 0734-211X

**Beschreibung**

Die Erfindung betrifft einen bildgebenden Energiefilter für elektrisch geladene Teilchen, wie Elektronen und Ionen, mit mindestens zwei toroidalen, hintereinander angeordneten Energieanalysatoren, wobei mindestens ein Energieanalysator in seiner Eintritts- und Austrittsebene jeweils eine Blende aufweist. Die Erfindung bezieht sich auch auf die Verwendung solcher bildgebender Energiefilter.

Die Blenden in den Ein- und Austrittsebenen können sich senkrecht zur jeweiligen energiedispersiven Ebene erstreckende Schlitzblenden oder kreisförmige Blenden sein.

Unter Energiefilter werden bevorzugt abbildende oder bildgebende Energiefilter verstanden. Die Verwendung bildgebender Filter ist besonders vorteilhaft, wenn die parallel verarbeiteten Bildfelder mehr als 100 x 100 Bildelemente (pixels) enthalten. Die Registrierzeiteri fallen dann wesentlich kürzer aus als in einem sequentiell die Probe abtastenden Spektrometer.

Energiefilter werden zum Beispiel in der Photoelektronenspektroskopie eingesetzt, die eine der wichtigsten Methoden zur quantitativen Elementanalyse von Oberflächen ist. Die Kombination von hoher Ortsauflösung zusammen mit der Messung der Photoelektronen-Energieverteilung wird Spektromikroskopie genannt. Um hohe Ortsauflösung zu erreichen, werden im Wesentlichen zwei verschiedene Methoden verwandt.

Bei der ersten Variante wird ein gebündelter Photonenstrahl über die Probe gerastert und die von dem so definierten Emissionsfleck kommenden Photoelektronen werden nach ihrer Energie analysiert.

Beim zweiten Verfahren wird der Photonenstrahl gerade genug fokussiert, um den Sichtbereich der Objektivlinse auszuleuchten. Die Intensitätsverteilung der erzeugten Photoelektronen wird elektronenoptisch vergrößert abgebildet.

Um eine Karte der Elementverteilung oder der chemischen Bindung ableiten zu können, müssen die Photoelektronen nach ihrer kinetischen Energie analysiert werden. Für die Transmissionselektronenmikroskopie wurden dazu verschiedene Techniken entwickelt. Im Wesentlichen gibt es auch hier zwei unterschiedliche Prinzipien:

Es gibt Mikroskope, die alle Elektronen nutzen, um ein Bild zu erzeugen, wobei ein kleiner Teil der Elektronen durch einen Energieanalysator geht, um ein Spektrum von einem Teil des Bildes zu erzeugen. Ein anderer Teil der Mikroskope benutzt nur ein schmales Energieband, transportiert aber dafür ein komplettes Bild durch den Energieanalysator.

Die Elektronen werden durch elektrostatische oder magnetische Vorrichtungen gefiltert, die nur den Elektronen mit einer bestimmten Energie den Durchtritt ermöglichen. Die Intensität des resultierenden Strahls spiegelt die Konzentration eines vorliegenden chemischen Bestandteils der Probenoberfläche wieder. Bei diesem Verfahren soll die Ortsauflösung beim Durchtritt durch den Monochromator nicht verschlechtert werden.

Eine Reihe von Energieanalysatoren ist für diese Abbildungsfunktion entwickelt worden. Für die Energieanalyse ohne Abbildungsqualität hat der Halbkugelanalysator bei kommerziellen Geräten sich wegen seiner guten Transmission und Energieauflösung in der Anwendung durchgesetzt.

Die möglichen Abbildungseigenschaften von elektrostatischen Energieanalysatoren wurden bereits vor vielen Jahren für Analysatoren mit allgemeinen toroidalen Feldern untersucht (B.Wannberg, G.Engdahl, A. Sköllermo, Imaging Properties of electrostatic Energy Analyzers with toroidal fields, J. Electron Spectr. Rel. Phenomen. 9 (1976), 111 -127. Für ein toroidales Potential ist der Krümmungsradius in der einen Richtung ein anderer als senkrecht dazu. Als Spezialfall ist der Kugelkondensator mit einem Radienverhältnis gleich 1 in dieser verallgemeinerten Darstellung enthalten. Ein Zylinderkondensator ist nur in einer Richtung gekrümmt, sein Radienverhältnis ist gleich null. Es gibt Spektrometer, wo der Übergang zwischen den Feldformen kontinuierlich eingestellt werden kann, wie dies beispielsweise in K. Jost, Novel Design of a spherical electron spectrometer, J. Phys. E: Sci. Instr. 12, 1979, S. 1006 -1012 beschrieben wird.

Aus der EP 0293924 B1 ist ein Elektronenmikroskop mit einem Energiefilter bekannt, der einen sphärischen Analysator mit einem halbkugelförmigen Aufbau umfasst. Um die Abbildungsqualität des Energiefilters zu verbessern, ist vor dem Eintrittsspalt ein aufwendiges Linsensystem angeordnet, um möglichst senkrecht auftreffende Elektronenstrahlen zu erzeugen. Für Elektronen, die am mittleren Bahnradius $r_0 = x_0$ starten, soll gelten $\alpha_0 = -\alpha_1$, wobei $\alpha_0$ den Eintrittswinkel und $\alpha_1$ den Austrittswinkel aus dem Energiefilter bezeichnet.

Die Eintrittswinkel werden angeblich für diese Elektronen exakt auf den Austrittswinkel übertragen und zwar unabhängig von ihrer Energie.

Um diese Eigenschaft zu nutzen, wird ein vergrößertes Bild der Probe nicht in den Eintrittsschlitz des Analysators gelegt, sondern in den Brennpunkt einer Linse, die vor der Schlitzblende des Analysators angebracht ist. Damit wird die Position des Bildes in Winkel transformiert. Die Eintrittsschlitzblende wird in den bildseitigen Brennpunkt der Linse gelegt.

Der Austrittsschlitz des Analysators selektiert den gewünschten Energiebereich. Eine weitere Linse hinter dem Analysator rekonstruiert aus dem transmittierten Winkelbild ein jetzt nach der Energie gefiltertes Ortsbild. Dieses kann weiter vergrößert werden und mit Hilfe eines Intensitätsverstärkers, z. B. einer Mikrokanalplatte, auf einem Leuchtschirm sichtbar gemacht werden.

Ein Etektronenspektrometer mit einer ähnlichen Anordnung wird in der EP 02 46 841 B1 beschrieben. Mit diesem Energieanalysator des Torroid- Kondensatortyps mit vor- und nachgeschaltetem Linsensystem wird eine Ortsauflösung von bis zu 2, 5 $\mu$m erreicht.

Hierbei wurde jedoch übersehen, dass die Gleichung $\alpha_1$ = -$\alpha_0$ im allgemeinen nur eine grobe Nährung darstellt. In Nucl. Instr. Methods A291 (1990) Seite 60-66 wird gezeigt, dass Ein- und Austrittswinkel auch vom Ein- und Austrittsort abhängen. Ein- und Austrittswinkel unterscheiden sich deutlich, wenn Ein- und Austrittspositionen unterschiedlich sind. Es gilt dann (tan $\alpha_0$): $x_0$ = -(tan $\alpha_1$): $x_1$.

Die Aberrationen nehmen mit vergrößertem Bildfeld, also einem möglichen Unterschied zwischen $x_1$ und $x_0$ zu. Das folgende Beispiel verdeutlicht ihre Größe:

Bei einem Sichtfeld von 4 mm Durchmesser, also z. B. $x_0$ = 122 mm und $x_1$ = 126 mm zusammen mit einem Akzeptanzwinkel von $\alpha_0$ = 5° berechnet man einen Ausfallswinkel von $\alpha_1$ = 5,16 °. Das sind 3 % Abweichung vom Einfallswinkel. Daraus ergibt sich bei einem Blickfeld von 100 $\mu$m Radius ein Abbildungsfehler von 3 $\mu$m am Bildfeldrand.

Auch für Elektronen mit gleicher Eintrittsposition unter unterschiedlichem Eintrittswinkel ergibt sich eine unterschiedliche Austrittsposition und ein unterschiedlicher Austrittswinkel gemäß

$$\tan \alpha_1 = \tan \alpha_0 \left( 1 - \frac{2}{\cos^2 \alpha_0} \right)^{-1}$$

Dies wird beispielsweise in T. Sagara et al., Resolution improvements for hemispherical energy analyzers, Rev. Sci. Instr. 71, 2000, 4201-4207 beschrieben.

Ein anderes Beispiel benutzt einen Halbkugelanalysator in einem anderen Betriebsmodus. Hier sind die Potentiale so gewählt, dass sich die Elektronen auf einer Hyperbelbahn in einem quadratisch mit dem Radius ansteigenden Feld bewegen.

Im US-Patent 5,185,524 wird ein elektrostatischer sphärischer Spiegel-Analysator beschrieben. Die Elektronen treten durch Schlitze in die innere Kugel ein und werden durch ein Gegenfeld durch die Innenkugel hindurch wieder zu einem Fokus gebracht. Gegenstand und Bild befinden sich innerhalb der Innenkugel.

Nachteile dieser Anordnung werden in Nucl. Instr. Methods 42, 1966, 71-76 beschrieben. In der inneren Kugel befinden sich große Schlitze, wobei sich diese Schlitze nicht an der Stelle eines kleinen Strahlquerschnitts befinden. Um das an diesen Stellen erforderliche sphärische Potential sicherzustellen, werden an dieser Stelle Netze angebracht. Der verbleibende Felddurchgriff durch die Maschen begrenzt das erreichbare Ortsauflösungsvermögen. Jede Netzmasche stellt eine kleine Streulinse dar. Ein weiterer Nachteil von Netzen im Strahlengang ist das Auslösen von Sekundärelektronen, welches zu einem erhöhten Untergrund führt und dadurch den darstellbaren Kontrast verringert. Der energieselektierende Spalt befindet sich im elektrischen Feld zwischen den Hemisphären, ist also zwecks Verstellung nur schwer zugänglich. Die Spannungen, welche an die Außenkugel gelegt werden müssen, sind deutlich höher als beim konventionellen Halbkugelanalysator.

In diesem Design, wie auch in dem Vorigen gibt es inhärente Bildfehler, die auf die nur zweizählige Symmetrie des Aufbaues zurückgehen.

In der DE 196 33 496 A1 wird ein Monochromator für die Elektronenmikroskopie vorgestellt, welcher spiegelsymmetrisch aufgebaut ist. Der Aufbau in Form eines $\Omega$ vermeidet Fehler zweiter Ordnung und auch einige Fehler dritter Ordnung verschwinden. Für den gewählten Aufbau war ein wesentliches Design-Kriterium das Vermeiden eines Zwischenfokus. Damit soll ermöglicht werden, einen primären Elektronenstrahl mit kleinem Durchmesser und hoher Stromdichte monochromatisieren zu können. Diese Forderung führt zu einer Lösung, die mechanisch aufwändig ist Der Aufbau besteht aus acht toroidalen Sektoren, die sehr präzise zueinander justiert werden müssen. Das macht die Herstellung sehr kosten- und die Justage sehr zeitaufwendig.

In der EP 0 470 299 A1 wird eine ähnliche spiegelsymmetrische Anordnung von Monochromatoren gewählt. Diese Anordnung enthält ebenfalls keine Zwischenlinse, sondern ein gerades Verbindungsrohr.

Der energieselektierende Schlitz befindet sich in der Symmetrieebene. Auch hier ist keine Verwendung zur Abbildung vorgesehen.

Aus der US 5,466,933 ist ein Energiefilter bekannt, der aus einem komplementären gegenüberliegenden Paar von 90 ° Sektoren besteht die derart zueinander angeordnet sind, dass sie eine S-Form bilden. Zwischen den beiden Sektoren ist eine Aperturblende angeordnet. Mit diesem Energiefilter werden die ankommenden parallelen Elektronenstrahlen am Ausgang der Sektoranordnung abgebildet.

Mit dieser Anordnung unter Verwendung von parallelen Elektronenstrahlen wird zwar eine kontrastreiche Abbildung am Ausgang des Energiefilters erzielt, allerdings ist die am Ausgang ankommende Intensität äußerst gering. Eine Intensitätssteigerung kann zwar dadurch erzielt werden, dass auch Elektronen mit Eintrittswinkel $\alpha_0$ ungleich 0 zugelassen werden, allerdings tritt dann eine Verschmierung der Bildpunkte und somit eine Kontrastminderung auf.

In der WO 01/61725 A1 wird ein Emissionselektronenmikroskop beschrieben, welches einen Abbildungsstrahlengang enthält bestehend aus einem elektronenoptischen Abbildungssystem, das den Elektronenstrahl parallel verschiebt und energetisch analysiert. Es besteht aus zwei sphärischen Energieanalysatoren mit einer dazwischen geschalteten Linse. Diese Linse befindet sich im Fokuspunkt beider Analysatoren. In der Mitte dieser Linse wird ein Zwischenbild der Probe oder das Winkelbild der Probe gelegt. Da bei Feldlinsen die Vergrößerung positiv ist, werden Bildfehler, die beim Durchgang durch den ersten Ablenker entstehen, nicht korrigiert. Der Anspruch der Bildfehler-Korrektur wird in dieser Schrift auch nicht erhoben und nicht diskutiert.

In der DE 30 14 785 A1 wird ein Doppel-Monochromator für geladene Teilchen beschrieben, der eine Verzögerungslinse in Form von Schlitzblenden zwischen den Teil-Monochromatoren enthält. Der Monochromator wird ohne Einbuße von Energieauflösung mit höheren Intensitäten beschrieben als dies bisher möglich war. Es wird keine Linse angegeben, welche die bildgebenden Eigenschaften des Systems verbessert. Auch in der US 4,742,223 werden Schlitzblenden beschrieben. Auf bildgebende Eigenschaften des Systems wird nicht eingegangen.

In der US 5,448,063 wird ein abbildender spiegelsymmetrischer Energiefilter beschrieben, welcher nur die Bildfehler 2. und 3. Ordnung kompensiert. Diese Bildfehlerkorrektur wird nur durch einen hohen apparativen Aufwand erreicht, indem zusätzliche Hexapolfelder eingesetzt werden.

Aufgabe der Erfindung ist es daher, einen bildgebenden Energiefilter mit minimalen Bildfehlern zu schaffen, der sowohl eine kontrastreiche Abbildung bei hoher Ortsauflösung als auch eine hohe Intensität an seinem Ausgang gewährleistet.

Diese Aufgabe wird mit einem Energiefilter gelöst, der dadurch gekennzeichnet ist, dass zwischen der Austrittsebene des ersten Energieanalysators und der Eintrittsebene des zweiten Energieanalysators eine Transferlinseneinrichtung angeordnet ist, die eine negative laterale Vergrößerung $V_L$ und eine negative Winkelvergrößerung $V_W$, eine Bilddrehung um den Winkel $\gamma = \beta - 180°$ und einen teleskopischen Strahlengang aufweist, wobei ihre jeweiligen Ablenkwinkel $\phi$ gleichgroß sind und ihre energiedispersiven Ebenen (33, 43) um den Winkel $\beta$ zueinander gedreht sind.

Die Drehung der Energieanalysatoren erfolgt um die Achse der Transferlinseneinrichtung.

Unter einem teleskopischen Strahlengang wird ein Strahlengang verstanden, bei dem jedes parallele Strahlenbündel unabhängig vom Einfallswinkel in ein paralleles Strahlenbündel überführt wird. Der Winkel $\gamma$ bezeichnet die Drehung des Bildes aus seiner inversen Position. Diese inverse Position wird z. B. mittels elektrostatischer Linsen erreicht wird.

Der Vorteil des Energiefilters besteht darin, dass nicht zwingend mit senkrecht auf die Eintrittsebene des ersten Energieanalysators auftreffenden Teilchenstrahlen gearbeitet werden muss, d.h. dass der Eintrittswinkel $\alpha_0$ ungleich 0 zugelassen werden kann, so dass am Ausgang des Energiefilters ein kontrastreiches Bild hoher Intensität erzeugt werden kann. Die am Ausgang des ersten Energieanalysators auftretenden Bildfehler, insbesondere Bildfehler zweiter Ordnung, werden durch die Transferlinseneinrichtung auf die Eintrittsebene des zweiten Energieanalysators transformiert, so dass beim Durchlaufen der geladenen Teilchen durch den zweiten Energieanalysator diese Bildfehler vollständig aufgehoben werden.

Die Abbildungsqualität des Energiefilters ist im Wesentlichen nur durch die Qualität der Transferlinseneinrichtung begrenzt.

Vorzugsweise ist die Transferlinseneinrichtung derart ausgelegt, dass sie in der energiedispersiven Ebene das Zwischenbild $ZB_1$ in der Austrittsebene des ersten Energieanalysators mit einer Linearvergrößerung $V_L = \dfrac{ZB_2}{ZB_1} < 0$ und mit einer Winkelvergrößerung $V_W = \dfrac{\alpha_2}{\alpha_1} < 0$ mit $V_W V_L \sqrt{\dfrac{E_2}{E_1}} = 1$ verdreht um den Winkel $\gamma = \beta - 180°$ auf die

Eintrittsebene des zweiten Energieanalysators als Zwischenbild der Größe $ZB_2$ abbildet, wobei $\alpha_1$ der Austrittswinkel der geladenen Teilchen aus der Austrittsebene des ersten Energieanalysators, $\alpha_2$ der Eintrittswinkel in die Eintrittsebene des zweiten Energieanalysators, $E_1$ die kinetische Energie der geladenen Teilchen in der Austrittsebene des ersten Energieanalysators und $E_2$ die kinetische Energie der geladenen Teilchen in der Eintrittsebene des zweiten Energieanalysators bezeichnet und wobei die geladenen Teilchen in der Transferlinseneinrichtung einen teleskopischen Strahlengang durchlaufen.

Für eine elektrostatische Transferlinseneinrichtung ist $\beta = 180°$ und $V_L$ und $V_W$ sind negativ. Für eine magnetische Transferlinseneinrichtung sind $V_L$ und $V_W$ negativ und es kann zu einer Bilddrehung kommen, so dass $\beta \neq 180°$ gewählt werden muss.

Vorzugsweise sind die Energieanalysatoren und die Transfertinseneinrichtung punktsymmetrisch um das Zentrum Z der Transferlinseneinrichtung angeordnet. Dies bedeutet, dass die Energieanalysatoren gleiche Baugröße aufweisen und dass $V_L = -1$ und $V_W = -1$ ist.

Die Energieanalysatoren können aber auch unterschiedliche Baugrößen aufweisen, wodurch eine quasi-punktsymmetrische Anordnung geschaffen wird, bei der $V_W$ und $V_L$ kleiner 0 sind.

$V_w = V_L = -1$ kann dadurch eingestellt werden, dass die Radien und die Pass-Energien entsprechend aufeinander abgestimmt werden.

Im Rahmen der Erfindung steht es grundsätzlich frei, welche Art von Ablenkfeldern für die Analysatoren eingesetzt werden. Neben magnetischen Feldern, die permanent oder durch Ströme erzeugt werden können, ist die Verwendung elektrostatischer Felder besonders bevorzugt.

Vorzugsweise sind die toroidalen Energieanalysatoren Kugelsektoren oder Zyünderanalysatoren, insbesondere mit einem Ablenkwinkel von mehr als 90°.

Insbesondere sind Halbkugelanalysatoren mit Ablenkwinkeln von $\Phi = 180°$ bevorzugt, weil diese eine besonders große Energiedispersion an ihrem Ausgang aufweisen.

In einem sphärischen Feld, bei dem die potentielle Energie des Teilchens $\sim \dfrac{1}{r}$ ist, bewegen sich die geladenen Teilchen auf geschlossenen Ellipsenbahnen. Alle an einem Punkt mit unterschiedlicher Energie und auch verschiedenen Winkeln startenden Teilchen haben nach einem Umlauf von 360° exakt wieder ihre Anfangsposition erreicht, so dass keine Bildfehler am Ausgang auftreten. In einem solchen geschlossenen Kugelanalysator würden die beiden energiedispersiven Ebenen der beiden Halbkugeln definitionsgemäß den Winkel $\beta = 0$ einschließen. Nach einem Umlauf von 180 ° haben die Teilchen mit unterschiedlichen Energien einen maximalen radialen Abstand voneinander. Bringt man hier eine Apertur an, welche das radiale Feld nicht stört, so erlaubt man nur Teilchen einer gewünschten Energie den Durchtritt. Allerdings wäre in einem solchen geschlossenen Kugelanalysator kein Platz zur Unterbringung von beispielsweise einer Eintrittslinse und einem Detektor oder der Transferlinse.

Bei zwei Halbkugelanalysatoren, die derart zueinander angeordnet sind, dass ihre energiedispersiven Ebenen um den Winkel $\beta$ gedreht sind, können die Eigenschaften eines vollständigen Kugelanalysators durch die abbildenden Eigenschaften der Transferlinseneinrichtung beibehalten werden, so dass am Ausgang des Energiefilters ebenfalls fehlerfreie Bilder entstehen. Die Transferlinseneinrichtung sorgt dafür, dass die Bahnen mit exakter Abbildung beibehalten werden, wobei lediglich der Eintrittspunkt in dem ersten Halbkugelanalysator räumlich vom Austrittspunkt im zweiten Halbkugelanalysator getrennt wird.

Es entsteht somit in der Wirkung ein sphärischer Kugelkondensator. Es ist bekannt, dass nicht relativistische Teilchen geschlossene periodische Ellipsenbahnen durchlaufen. Nach einem vollständigen Umlauf bleiben Winkel und Position erhalten. Das ist unabhängig von der Startposition, dem Eintrittswinkel oder der Energie der geladenen Teilchen.

Vorzugsweise ist die energiedispersive Ebene der Halbkugelanalysatoren um $\beta = 180°$ um die Achse der Transferlinseneinrichtung gedreht angeordnet, so dass der Strahlengang eine S-förmige Gestalt aufweist. Diese Anordnung hat den Vorteil, dass eine besonders einfache Transferlinseneinrichtung verwendet werden kann.

Aus praktischen Gründen wird der Winkel $\beta$ zwischen den Dispersionsebenen vorzugsweise aus dem Winkelbereich von 5° bis 355°, insbesondere von 15° bis 340°, gewählt.

Die Energieanalysatoren können unterschiedlich ausgelegt sein, was wiederum bei der Auslegung der Transferlinseneinrichtung berücksichtigt werden muss. Die laterale Vergrößerung und die Winkelvergrößerung müssen bei unterschiedlichen Energieanalysatoren, z.B. bei unterschiedlichen Pass-Energien $E_1$ und $E_2$, bei der Abbildung des Zwischenbildes auf der Eintrittsebene des zweiten Energieanalysators angepasst werden. Bei der Auslegung der Transferlinseneinrichtung ist daher die Lagrange-Helmholtz-Beziehung $ZB_1 \cdot \alpha_1 \cdot \sqrt{E}_1 = \text{const.} = ZB_2 \cdot \alpha_2 \cdot \sqrt{E}_2$ berücksichtigen.

Unter Kostengesichtspunkten ist es jedoch von Vorteil, wenn identische Energieanalysatoren verwendet werden und mit der gleichen Pass-Energie betrieben werden. In diesem Fall ist die laterale Vergrößerung der Transfertinseneinrichtung $V_L = -1$ und die Winkelvergrößerung der Transferlinseneinrichtung $V_W = -1$.

Vorzugsweise umfasst die Transferlinseneinrichtung mindestens eine elektrostatische Linse, insbesondere eine elektrostatische Rohrlinse, die insbesondere in Verbindung mit zwei Haibkugelanalysatoren verwendet wird, deren energiedispersive Ebenen vorzugsweise um den Winkel $\beta = 180°$ gedreht zueinander angeordnet sind.

Die Transferlinseneinrichtung kann mindestens eine Magnetlinse umfassen. Magnetlinsen haben den Vorteil, dass sie kleinere Aberrationen aufweisen als elektrostatische Linsen. Sie werden daher bevorzugt dann eingesetzt, wenn auf Grund von um den Winkel $\beta$ verdreht angeordneter Energieanalysatoren das Zwischenbild $ZB_1$ ebenfalls um den Winkel $\gamma = \beta - 180°$ verdreht abgebildet werden muss.

Vorzugsweise weist die Transferlinseneinrichtung mindestens zwei Linsen auf.

Vorteilhafterweise ist die Austrittsebene des ersten Energieanalysators im Brennpunkt der ersten Linse und die Eintrittsebene des zweiten Energieanalysators im Brennpunkt der zweiten Linse angeordnet, wobei der Abstand beider Linsen 2F beträgt und F die Brennweite der beiden Linsen bezeichnet.

Die Transferlinseneinrichtung kann auch mindestens eine elektrostatische oder magnetische Multipollinse umfassen. Multipollinsen haben den Vorteil, dass mit ihnen eine Abbildung ganz ohne sphärische Aberrationen realisiert werden kann. Eine Multipollinse wird derart zwischen den beiden Energieanalysatoren angeordnet, dass sich ein punktsymmetrischer Aufbau ergibt.

Eine Möglichkeit der Verwendung sieht vor, dass der Energiefilter in dem Abbildungsstrahlengang eines abbildenden elektronenoptischen Systems angeordnet wird. Die Aufgabe des Energiefilters besteht darin, durch entsprechende Einstellung der Blenden des Energiefilters Elektronen bestimmter Energien aus dem Strahlengang zu selektieren. Es ist hierbei unerheblich, ob ein Zwischenbild von der zu untersuchenden Probe, das fouriertransformierte Zwischenbild oder eine andere Intensitätsverteilung des abbildenden Strahlengangs in den Eintrittsschlitz des Energieanalysators gelegt wird. Durch Veränderung des Energiefensters lassen sich die Energien dieser geladenen Teilchen sowie die Energiebreite des erfassten Strahlenganges bestimmen und variieren.

Ein bevorzugter Einsatz betrifft den Einsatz in der Elektronenmikroskopie. Hierbei wird das Energiefilter bei der Abbildung der vom Objekt emittierten oder rückgestrahlten Elektronen eingesetzt. Diese Elektronen haben von Natur aus eine hohe Energiebreite. Eine Verbesserung des Kontrastes lässt sich durch Nutzung von Elektronen aus einem schmalen Energieband erreichen. Durch selektives Setzen des Energiefensters können sukzessive bestimmte Signale herausgegriffen und verstärkt und andere demgegenüber abgeschwächt werden. Eine gezielte Hervorhebung bestimmter Informationen ist auf diesem Wege möglich.

Eine weitere bevorzugte Verwendung des Energiefilters betrifft die Verwendung für zeitaufgelöste Messvorrichtungen. Der Vorteil des Energiefilters besteht darin, dass auch Flugzeitunterschiede, die im ersten Energieanalysator auftreten, durch die Transferlinseneinrichtung verbunden mit dem Durchlauf durch den zweiten Energieanalysator aufgehoben werden.

Beispielhafte Ausführungsformen der Erfindung werden nachfolgend anhand der Zeichnungen näher erläutert.

Es zeigen:

Figur 1     eine schematische Darstellung eines Energiefilters mit zwei Halbkugelanalysatoren,

Figur 2     eine schematische Darstellung einer Transferlinseneinrichtung,

Figur 3     eine Ausführungsform der in Figur 1 gezeigten Anordnung,

Figur 4     eine perspektivische Darstellung der in Figur 3 gezeigten Darstellung,

Figur 5     eine weitere Ausführungsform, die sich von der in Figur 4 gezeigten Ausführungsform durch einen anderen Drehwinkel unterscheidet,

Figur 6     eine schematische Darstellung einer weiteren Ausführungsform mit Kugelsektoren als Energieanalysatoren,

Figur 7     eine weitere Ausführungsform mit insgesamt vier Toroidsektoren,

Figur 8     einen Energiefilter mit Zylinderanalysatoren,

Figur 9     eine Transferlinseneinrichtung mit Multipollinsen und

Figur 10     eine Transferlinseneinrichtung mit Magnetlinsen.

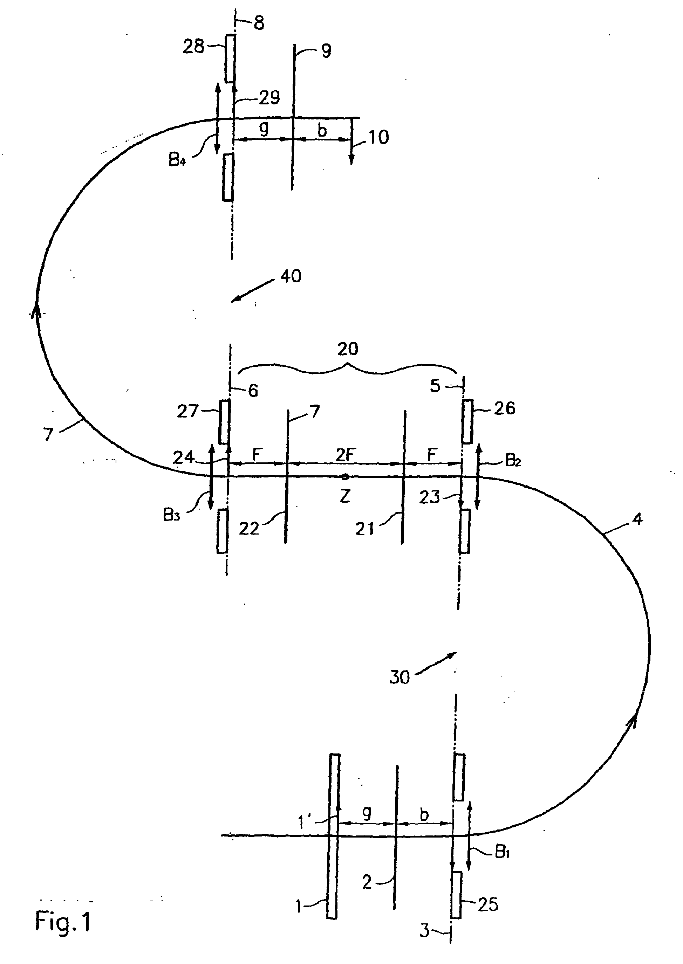

In der Figur 1 ist ein schematischer Querschnitt durch einen Energiefilter dargestellt, der zwei Halbkugelanalysatoren 30 und 40 aufweist, zwischen denen eine Transferlinseneinrichtung 20 angeordnet ist. Die beiden Energieanalysatoren 30, 40 zusammen mit der Transfertinseneinrichtung 20 sind derart angeordnet, dass der Strahlengang in einer Ebene liegt und eine S-förmige Gestalt aufweist.

Die Gesamtanordnung ist punktsymmetrisch bezüglich des Zentrums Z der Transferlinseneinrichtung 20, wobei die Punktsymmetrie zweizählig ist.

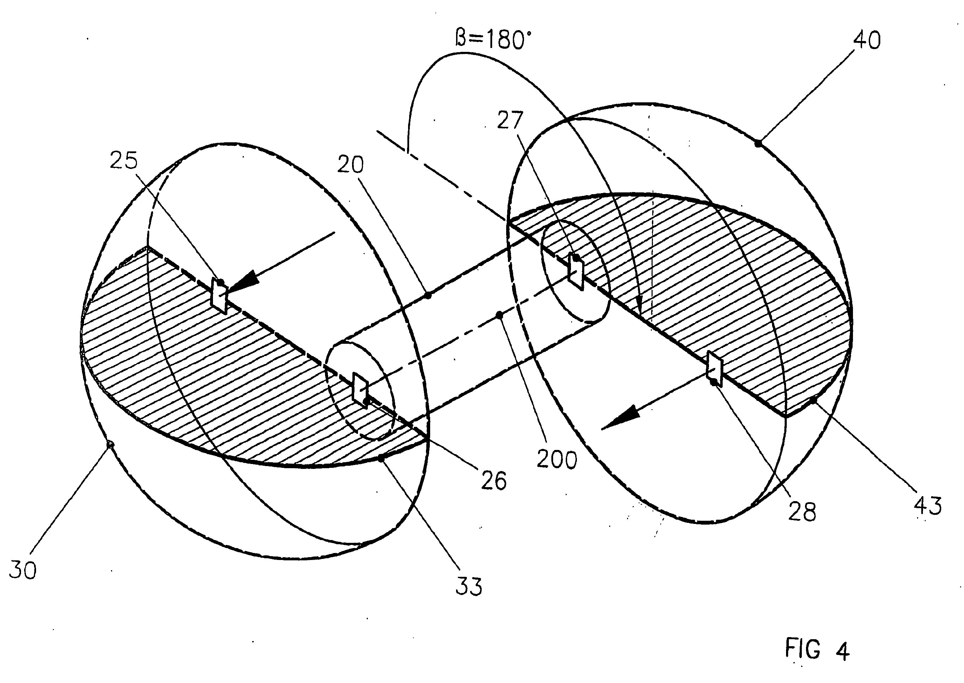

Hierbei durchlaufen die Elektronen im ersten Energieanalysator 30 eine Linkskurve und nach dem Durchlaufen der Transferlinseneinrichtung 20 im zweiten Energieanalysator 40 eine Rechtskurve. Dies bedeutet, dass die beiden energiedispersiven Ebenen 33, 43 der beiden Energieanalysatoren um den Winkel β = 180° zueinander gedreht sind (siehe Figur 4).

In der Figur 1 sind lediglich die mittleren Strahlengänge 4 und 7 der Elektronen im ersten und zweiten Energieanalysator eingezeichnet. Der Energiefilter besitzt abbildende Eigenschaften unter Vermeidung von Abberationen zweiter und höherer Ordnung.

Die Oberfläche 1' der Probe 1 befindet sich im Abstand g von dem ersten Linsensystem 2, das die von der Oberfläche 1' austretenden Elektronen auf die Eintrittsebene 3 des ersten Halbkugelanalysators 30 abbildet.

Die Gegenstandsweite g kann auch gleich der Brennweite des Linsensystems 2 sein, so dass die Bildweite b ungefähr gleich unendlich wird. In diesem Fall wird vorzugsweise die Eintrittsebene 3 des ersten Energieanalysators 30 in der beseitigen Brennebene des Linsensystems 2 angeordnet.

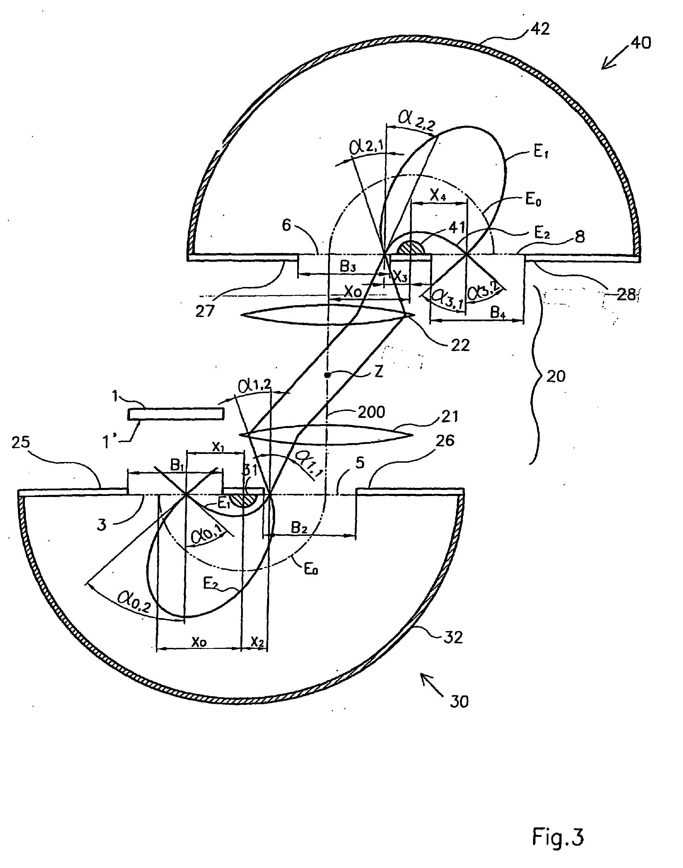

In der Eintrittsebene 3 befindet sich eine erste energiedefinierende Schlitzblende 25, die sich senkrecht zur Zeichenebene erstreckt und die Breite $B_1$ aufweist (s. auch Figur 3).

Der Halbkugelanalysator 30 bildet die durch die Schlitzblende 25 eintretenden Elektronen mit Abberationen in der Austrittsebene 5 ab, wo sich eine zweite Schlitzblende 26 der Breite B2 befindet.

Da die Elektronen in die in der Eintrittsebene 3 befindliche Schlitzblende 25 unter verschiedenen Eintrittswinkeln $\alpha_0$ eintreten, treten sie beim Verlassen des Ablenkfeldes des ersten Energieanalysators ebenfalls unter verschiedenen Austrittswinkeln $\alpha_1$ aus.

Die zweite Schlitzblende 26 erstreckt sich senkrecht zur Zeichenebene, in der der Unienfokus des astigmatischen Zwischenbildes $ZB_1$ 23 liegt. Die Energiedispersion erfolgt in der Zeichenebene, worunter eine Abweichung vom mittleren Strahlengang 4 um einen Wert verstanden wird, der proportional der Energieabweichung ist. Durch Veränderung der Schlitzbreite $B_2$ (s. auch Figur 3) lässt sich selektiv die Energiebreite der von der Schlitzblende 26 durchgelassenen Elektronen einstellen bzw. verändern. Im Ergebnis erreichen nur jene Elektronen das Zwischenbild $ZB_1$ 23, die sich innerhalb dieser Energiebreite befinden. Der Elektronenstrahl ist im Ergebnis monochromatisch.

Dieser Austrittsebene 5 ist eine Transferlinseneinrichtung 20 nachgeordnet, die aus zwei identischen konvergenten Linsen 21 und 22 besteht und das in der Austrittsebene 5 erzeugte erste Zwischenbild 23 als umgekehrtes zweites Zwischenbild $ZB_2$ 24, d.h. $V_L = -1$, auf die Eintrittsebene 6 des zweiten Energieanalysators 40 abbildet.

Die Transferlinseneinrichtung 20 bildet das Zwischenbild $ZB_1$ 23 nicht nur umgekehrt, sondern auch unter Winkelumkehr auf die Eintrittsebene 6 ab, so dass für die Eintrittswinkel $\alpha_2$ in der Eintrittsebene 6 des zweiten Energieanalysators 40 $\alpha_2 = - \alpha_1$ gilt.

Im zweiten Energieanalysator 40 werden durch die Umkehrung des Astigmatismus des Zwischenbildes $ZB_1$ 23 in Verbindung mit der Umkehrung der Bahnkrümmung im Vergleich zum ersten Energieanalysator 30 die Bildfehler aufgehoben, so dass in der Austrittsebene 8 ein energiegefiltertes stigmatisches Bild 29 entsteht, das mittels des Linsensystems 9 auf einem Detektor 10 projiziert werden kann.

Auch der zweite Energieanalysator 40 besitzt in dieser Ausführung eine Schlitzblende 27 mit der Breite $B_3$ in der Eintrittsebene 6 und eine Schlitzblende 28 mit der Breite $B_4$ in der Austrittsebene 8.

Für den Fall, dass die Oberfläche 1' der Probe 1 oder ein vergrößertes oder verkleinertes Abbild im Abstand der Brennweite des Linsensystems 2 positioniert wird, ist auch das Linsensystem 9 im Abstand der Brennweite von der Austrittsebene 8 und der Detektor 10 im Abstand der Brennweite des Linsensystems 9 angeordnet.

In den Eintritts- und Austrittsebenen der beiden Energieanalysatoren 30, 40 befinden sich dann anstelle reeller Bilder Beugungsbilder. Falls man die Linsensysteme 2 und 9 asymmetrisch betreibt, kann man mit dem Energiefilter unter Vermeidung von Aberrationen zweiter und höherer Ordnung das Beugungsbild der Probe 1 erhalten. Die Linsensysteme werden "asymmetrisch betrieben" genannt, wenn entweder mithilfe des Linsensystems 2 die Oberfläche der Probe in die Eintrittsebene 3 gelegt wird und das Linsensystem 9 so eingestellt wird, dass das Zwischenbild 29 in der Brennweite des Linsensystems 9 liegt, oder umgekehrt das Linsensystem 2 so eingestellt wird, dass die Probenoberfläche (oder ihr Zwischenbild) in der Brennebene der Linse liegt und gleichzeitig die Ebene 8 mit dem Linsensystem 9 scharf auf dem Detektor 10 abgebildet wird.

Das Beugungsbild der Probe wird dann mithilfe des Linsensystems 2 in die Eintrittsebene 3 gelegt. Dieses Beugungsbild wird energetisch gefiltert und gelangt zur Austrittsebene 8. Von dort wird es mit dem Linsensystem 9 auf den Detektor 10 abgebildet.

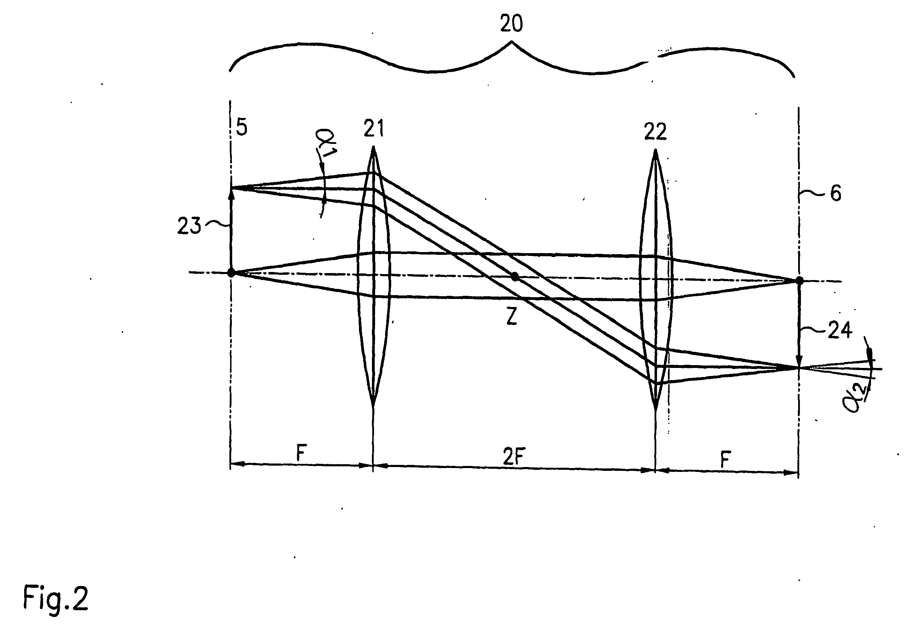

In der Figur 2 ist schematisch der Strahlengang in der Translerlinseneinrichtung 20 dargestellt. Die beiden identischen, elektrostatischen Sammellinsen 21, 22 weisen eine F-2F-F-Anordnung auf, wobei F die Brennweite der Linsen 21, 22 bezeichnet. Aufgrund dieser Linsenanordnung wird das erste Zwischenbild $ZB_1$ 23 in der Austrittsebene 5 mit der lateralen Vergrößerung $V_L = -1$ und das Strahlenbündel mit der Winkelvergrößerung $V_W = -1$ auf der Eintrittsebene 6 als zweites Zwischenbild $ZB_2$ 24 abgebildet. Der Strahlengang ist punktsymmetrisch und teleskopisch.

In der nicht dispersiven Ebene kann bei Verwendung anderer Linsen, z.B. elektronenoptische Zylinderlinsen, die Winkel- und Lateral-Vergrößerung auch + 1 betragen:

Die Figur 3 zeigt eine mögliche Ausführungsform der In Figur 1 schematisch dargestellten Anordnung mit drei möglichen Elektronenbahnen $E_0$, $E_1$ und $E_2$. Es ist ein Schnitt durch die energiedispersiven Ebenen dargestellt.

Die Elektronen starten von der Oberfläche 1' der Probe 1 und treten durch die Schlitzblende 25 mit der Breite $B_1$ in den ersten Halbkugelanalysator 30 ein, in dem zwischen der Innenschale 31 und der Außenschale 32 ein elektrostatisches Ablenkfeld angelegt ist.

Wenn die Elektronen senkrecht am Ort $X_0$ durch die Schlitzblende 25 eintreten, beschreiben sie die Bahn $E_0$, die im ersten und zweiten Halbkugelanalysator jeweils einen Halbkreis beschreibt.

Da die Bahn $E_0$ auf der Achse 200 der Transferlinseneinrichtung 20 auftrifft, wird sie ebenfalls am Ort $X_0$ der

Schlitzblende 27 des zweiten Halbkugelanalysators 40 abgebildet und durchläuft im zweiten Halbkugelanalysator eine Bahn, die punktsymmetrisch zum Punkt Z verläuft.

Die Elektronen auf der Bahn $E_1$ starten am Ort $X_1$ der Schlitzblende 25 des ersten Halbkugelanalysators 30 mit anderer Energie und dem Eintrittswinkel $\alpha_{0.1}$, während die Elektronen der Bahn $E_2$ im Ort $X_1$ mit dem Eintrittswinkel $-\alpha_{0.2}$ starten. Die Elektronen werden zum Punkt $X_2$ in der zweiten Schlitzblende 26 abgelenkt, wobei sie jeweils elliptische Bahnen beschreiben. Die Austrittswinkel sind $\alpha_{1.1}$ und $\alpha_{1.2}$, wobei in diesem Beispiel $|\alpha_{1.1}| = |\alpha_{1.2}|$ gewählt wurde.

Der Bildpunkt $X_0$ des ersten Zwischenbildes $ZB_1$ in der Schlitzblende 26 wird mit der lateralen Vergrößerung -1 und mit der Winkelvergrößerung -1 in der Ebene 6 am Ort $X_3$ als Bildpunkt des zweiten Zwischenbildes $ZB_2$ abgebildet. Für die Winkel gilt daher $\alpha_{1.2} = -\alpha_{2.2}$ und $\alpha_{1.1} = -\alpha_{2.1}$.

Im zweiten Energieanalysator 40 liegt zwischen der Innenschale 41 und der Außenschale 42 ein gleichstarkes elektrostatisches Ablenkfeld an, so dass die Elektronenbahnen $E_1$ und $E_2$ elliptische Bahnen durchlaufen, die den elliptischen Bahnen im ersten Energieanalysator 30 entsprechen. Die Elektronen treten am Ort $x_4$ unter den Winkeln $\alpha_{31}$ und $\alpha_{3.2}$ aus, die wiederum den Winkeln $\alpha_{0.1}$ und $\alpha_{0.2}$ entsprechen. Die Abweichung der Winkel $\alpha_{1.1}$ und $\alpha_{1.2}$ wird durch den zweiten Durchlauf durch den Energieanalysator 40 kompensiert. Auch bezüglich des Ortes $x_4$ gilt $x_4=x_1$. Es wird somit in der Ebene der Schlitzblende 28 ein energiegefiltertes Bild der Probe 1 ohne Abbildungsfehler erhalten.

In der Figur 4 ist die in Figur 3 gezeigte Ausführungsform perspektivisch dargestellt. In den Halbkugelanalysatoren 30 und 40 sind die energiedispersiven Ebenen 33 und 43 sowie die Schlitzblenden 25, 26, 27 und 28 eingezeichnet. Der zweite Halbkugelanalysator 40 ist um die durch die Schlitzblende 27 verlaufende Achse 200 der Transferlinseneinrichtung 20 um den Winkel $\beta = 180°$ gedreht angeordnet.

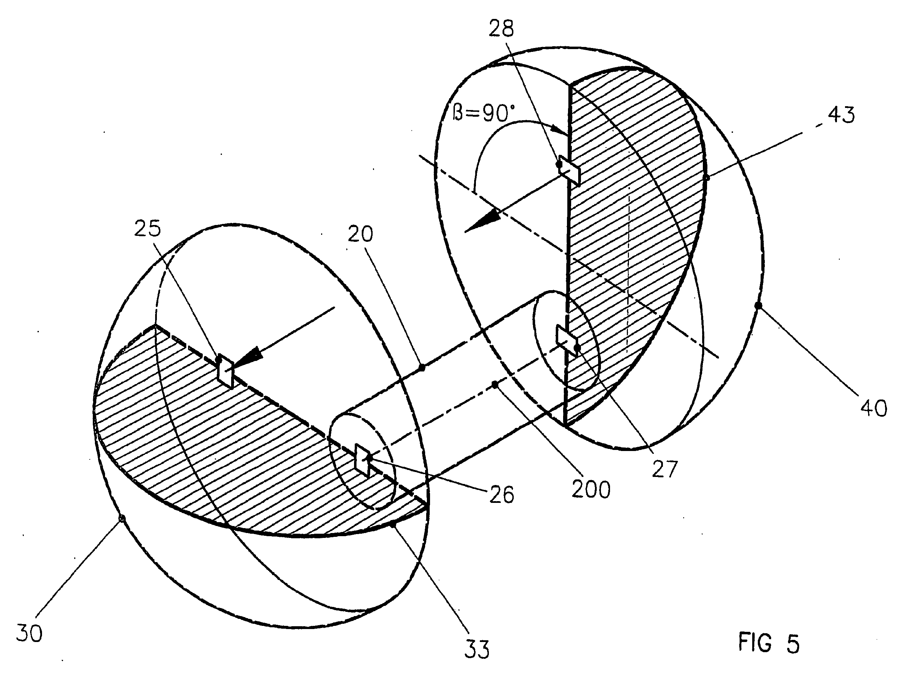

In der Figur 5 ist eine weitere Ausführungsform dargestellt, in der der zweite Halbkugelanalysator 40 lediglich um den Winkel $\beta = 90°$ um die durch die Schlitzblende 27 verlaufende Achse 200 gedreht angeordnet ist.

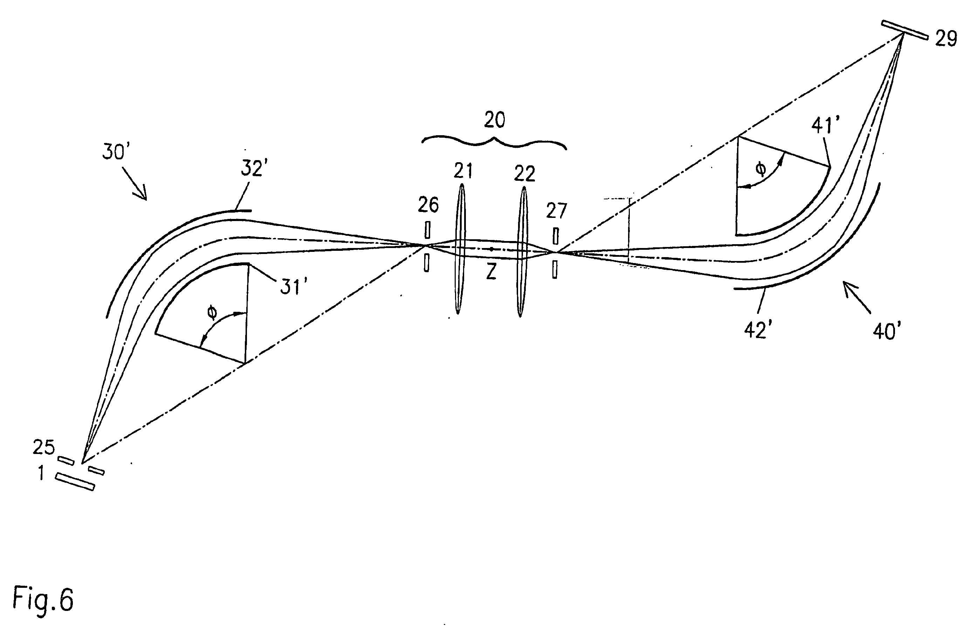

In der Figur 6 ist eine der Figur 3 entsprechende Ausführungsform dargestellt, wobei anstelle der Halbkugelanalysatoren 30, 40 jeweils Kugelsektoren 30' und 40' mit Innenschalen 31', 41' und Außenschalen 32', 42' verwendet werden, deren Ablenkwinkel $\Phi \leq 180°$ betragen. Die Anordnung der Blenden 25, 26 und 27 unterscheidet sich in der Anordnung in Fig. 3 dadurch, dass sie nicht in den Eintritts- bzw. Austrittsebenen der Kugelsektoren platziert sind. Auch diese Ausführungsform zeigt bezüglich des Punktes Z eine zweizählige Punktsymmetrie.

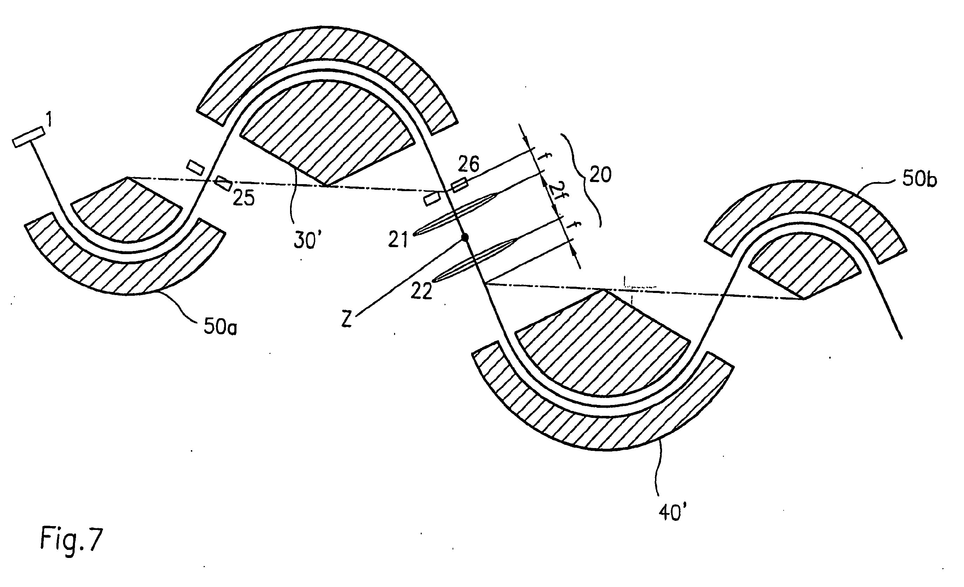

In der Figur 7 ist die in Figur 6 gezeigte Anordnung um zwei weitere Toroidsektoren 50a und 50b ergänzt, wobei der Toroidsektor 50a vor dem ersten Kugelsektor 30' und der Toroidsektor 50b hinter dem zweiten Kugelsektor 40' angeordnet ist. Diese zusätzlichen Toroidsektoren 50a und 50b dienen dazu, Aberrationen höherer Ordnung zu korrigieren.

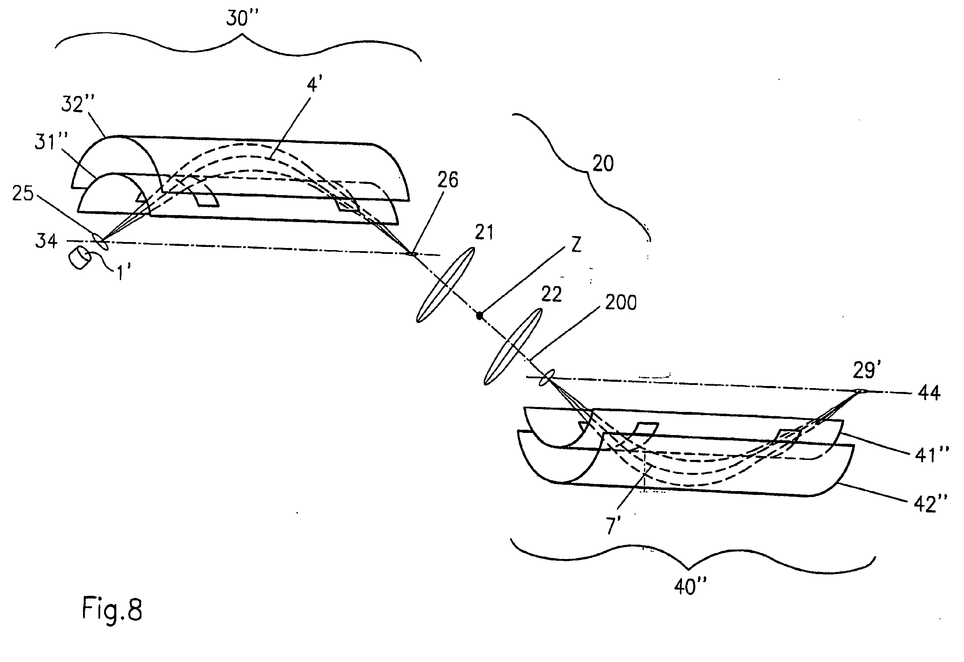

Figur 8 zeigt einen Energiefilter bestehend aus zwei Zylinderanalysatoren 30" und 40" mit Innenschalen 31", 41" und Außenschalen 32" und 42"und eine Transferlinseneinrichtung 20. Die Achse 200 des Transferlinsensystems 20 liegt nicht kollinear zu den Zylinderachsen 34 und 44, sondern in Richtung der mittleren Bahnen 4', 7' durch die Zylinderanalysatoren, welche einen Winkel von 42,3° mit den Zylinderachsen 34, 44 einschließen.

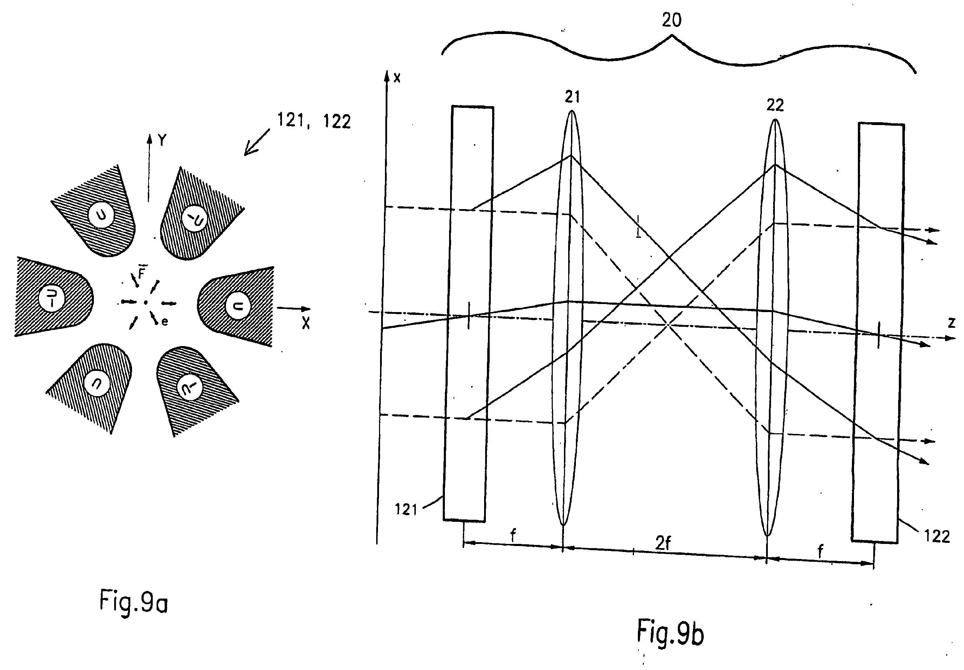

Die Figuren 9a, b zeigen eine Transferlinseneinrichtung 20, die sowohl die sphärische Abberation, als auch den Komafehler vermeidet. Dies lässt sich erreichen durch eine Kombination von elektrischen oder magnetischen Rundlinsen (21, 22) mit zwei Sextupol-Linsen 121 und 122. Die Achse 200 der Transferlinseneinrichtung entspricht der Richtung z.

In der Abbildung 9a ist ein achsensenkrechter Schnitt durch ein Sextupolsegment gezeigt. Die Kraft F auf ein Teilchen ändert ihre Richtung zwischen zwei benachbarten Elektroden, die in Bezug auf das Achsenpotential alternierend mit den Spannungen U bzw. -U belegt sind.

In Teilbild 9b ist schematisch der Verlauf der achsenfemen Bahnen zweier im xy-Schnitt achsenparallel einfallender Elektronen im Falle ausgeschalteter (gestrichelt) und erregter (durchgezogene Linie) Sextupole 121 und 122 dargestellt. Die achsennahe Bahn wird durch die Sextupole nur sehr wenig beeinflusst.

Die Sextupole liegen in der Austritts- bzw. Eintrittsebene 5, 6 der Energieanalysatoren.

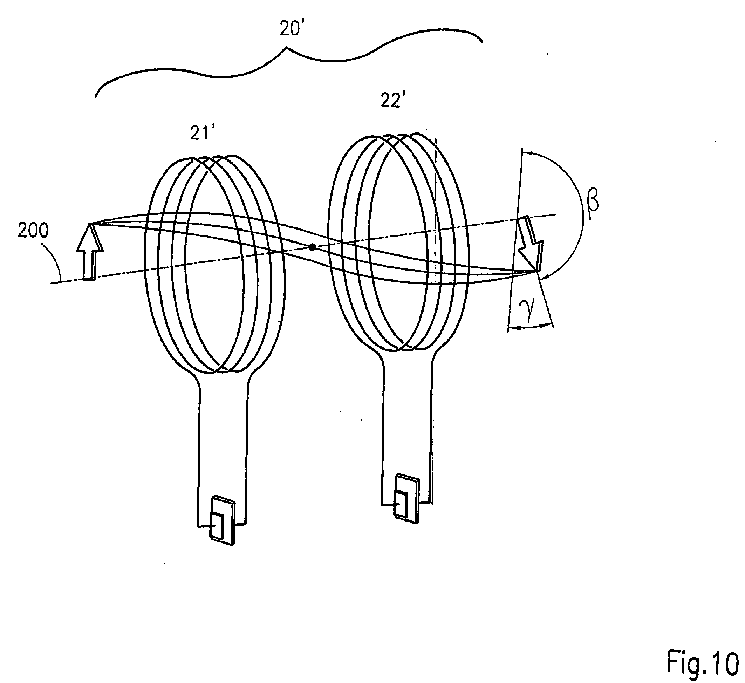

Figur 10 zeigt eine zu den elektrostatischen Linsen der Figur 2 analoge magnetische Transferlinseneinrichtung 20' in schematischer Darstellung. Das Magnetfeld der Linsen 22' und 21' wird durch Spulen erzeugt. Wesentlicher Unterschied zu einer elektrostatischen Transferlinseneinrichtung ist eine zusätzliche Verdrehung des Bildes, um den Winkel $\gamma$, wobei $\gamma$ auf die Position des Bildes für $V_L = -\dfrac{ZB_2}{ZB_1}$ bezogen ist.


**Bezugszeichen**

| | |
|---|---|
| 1 | Probe |
| 1' | Probenoberfläche |

| | |
|---|---|
| 2 | erstes Linsensystem |
| 3 | Eintrittsebene |
| 4, 4' | Mittlerer Strahlengang im ersten Energieanalysator |
| 5 | Austrittsebene |
| 6 | Eintrittsebene |
| 7, 7' | Mittlerer Strahlengang im zweiten Energieanalysator |
| 8 | Austrittsebene; |
| 9 | Linsensystem |
| 10 | Detektor |
| 20, 20' | Transferlinseneinrichtung |
| 21,21' | Erste Transferlinse |
| 22,22' | Zweite Transferlinse |
| 23 | Erstes Zwischenbild |
| 24 | Zweites Zwischenbild |
| 25 | Erste Schlitzblende |
| 26 | Zweite Schlitzblende |
| 27 | Dritte Schlitzblende |
| 28 | Vierte Schlitzblende |
| 29 | Bild |
| 30, 30', 30" | Erster toroidaler Energieanalysator |
| 31, 31', 31 " | Innenschale |
| 32, 32', 32" | Außenschale |
| 33 | energiedispersive Ebene |
| 34 | Achse |
| 40,40', 40" | Zweiter toroidaler Energieanalysator |
| 41, 41', 41" | Innenschale |
| 42, 42', 42" | Außenschale |
| 43 | energiedispersive Ebene |
| 44 | Achse |
| 50a, b | Toroidsektor |
| 121 | Sextupollinse |
| 122 | Sextupollinse |
| 200 | Achse der Transferlinseneinrichtung |

**Patentansprüche**

**1.** Bildgebender Energiefilter für elektrisch geladene Teilchen, wie Elektronen und Ionen, mit mindestens zwei toroidalen hintereinander angeordneten Energieanalysatoren, wobei mindestens ein Energieanalysator in seiner Eintritts- und Austrittsebene jeweils eine Blende aufweist, **dadurch gekennzeichnet,**
**dass** zwischen der Austrittsebene (5) des ersten Energieanalyeators (30, 30', 30") und der Eintrittsebene (6) des zweiten Energieanatysators (40, 40', 40'') eine Transferlinseneinrichtung (20, 20') angeordnet ist, die eine negative laterale Vergrößerung $V_L$ und eine negative Winkelvergrößerung $V_W$, eine Bilddrehung um den Winkel $\gamma = \beta - 180°$ und einen teleskopischen Strahlengang aufweist, wobei ihre jeweiligen Ablenkwinkel $\phi$ gleichgroß sind und ihre energiedispersiven Ebenen (33, 43) um den Winkel $\beta$ zueinander gedreht sind.

**2.** Energiefilter nach Anspruch 1, **dadurch gekennzeichnet, dass** die Transferlinseneinrichtung (20, 20') derart ausgelegt ist, dass sie in der energiedispersiven Ebene (33) das Zwischenbild $ZB_1$ (23) in der Austrittsebene (5) des ersten Energieanalysators (30, 30', 30") mit einer Linearvergrößerung von $V_L = \dfrac{ZB_2}{ZB_1} < 0$ und mit einer Winkelvergrößerung $V_W = \dfrac{\alpha_2}{\alpha_1} < 0$ mit $V_W V_L \sqrt{\dfrac{E_2}{E_1}} = 1$ verdreht um den Winkel $\gamma$ auf die Eintrittsebene (6) des zweiten Energieanalysators (40, 40', 40")) als Zwischenbild $ZB_2$ (24) abbildet,
wobei $\alpha_1$ der Austrittswinkel der geladenen Teilchen aus der Austrittsebene (5) des ersten Energieanalysators (30,

**9**

30', 30''), $\alpha_2$ der Eintrittswinkel in die Eintrittsebene (6) des zweiten Energieanalysators (40,40', 40''), $E_1$ die kinetische Energie der geladenen Teilchen in der Austrittsebene des ersten Energieanalysators (30, 30', 30'') und $E_2$ die kinetische Energie der geladenen' Teilchen in der Eintrittsebene des zweiten Energieanalysators (40, 40', 40'') bezeichnet und

wobei die geladenen Teilchen in der Transferlinseneinrichtung (20, 20') einen teleskopischen Strahlengang durchlaufen.

3. Energiefilter nach Anspruch 1 oder 2, **dadurch gekennzeichnet, dass** die Energieanalysatoren (30, 30', 30'', 40, 40', 40'') und die Transferlinseneinrichtung (20) punktsymmetrisch um das Zentrum der Transferlinseneinrichtung angeordnet sind.

4. Energiefilter nach Anspruch 1 oder 2, **dadurch gekennzeichnet, dass** die Energieanalysatoren (30, 30', 30'', 40, 40', 40'') unterschiedliche Baugrößen aufweisen.

5. Energiefilter nach einem der Ansprüche 1 bis 4, **dadurch gekennzeichnet, dass** die Energieanalysatoren Kugelsektoren (30', 40'), Halbkugelanalysatoren (30, 40) oder Zylinderanalysatoren (30'', 40'') sind.

6. Energiefilter nach Anspruch 5 **dadurch gekennzeichnet, dass** die energiedispersiven Ebenen (33, 43) der Halbkugelanalysatoren (30, 40) um den Winkel β = 180 ° um die Achse (200) der Transferlinseneinrichtung (20) gedreht angeordnet sind, so dass der Strahlengang eine S-förmige Gestalt aufweist.

7. Energiefilter nach einem der Ansprüche 1 bis 6, **dadurch gekennzeichnet, dass** die Transferlinseneinrichtung (20) mindestens eine elektrostatische Rohrlinse (21, 22) umfasst

8. Energiefilter nach einem der Ansprüche 1 bis 7, **dadurch gekennzeichnet, dass** die Transferlinseneinrichtung (20') mindestens eine Magnetlinse umfasst.

9. Energiefilter nach einem der Ansprüche 1 bis 8, **dadurch gekennzeichnet, dass** die Transferlinseneinrichtung (20) mindestens eine Multipollinse (121, 122) umfasst.

10. Energiefilter nach einem der Ansprüche 1 bis 9, **dadurch gekennzeichnet, dass** die Transferlinseneinrichtung (20) mindestens zwei Linsen (21, 21') und (22, 22') aufweist, und dass die Austrittsebene (5) des ersten Energieanalysators (30, 30', 30'') im Brennpunkt der ersten Linse (21, 21') und die Eintrittsebene (6) des zweiten Energieanalysators (40, 40', 40'') im Brennpunkt der zweiten Linse (22, 22') angeordnet ist, wobei der Abstand beider Linsen 2F beträgt und F die Brennweite der Linsen (21, 22, 21', 22') bezeichnet.

11. Verwendung eines Energiefilters nach einem der Ansprüche 1 - 10 für Elektronenmikroskope.

12. Verwendung eines Energiefilters nach einem der Ansprüche 1 -10 für zeitaufgelöste Messvorrichtungen.

## Claims

1. Imaging energy filter for electrically charged particles, such as electrons and ions, having at least two toroidal energy analysers arranged one behind the other, wherein at least one energy analyser has an aperture in its entrance plane and an aperture in its exit plane,
**characterised in that** there is disposed between the exit plane (5) of the first energy analyser (30, 30', 30'') and the entrance plane (6) of the second energy analyser (40, 40', 40'') a transfer lens device (20, 20') exhibiting a negative lateral magnification $V_L$ and a negative angular magnification $V_W$, an image rotation by the angle γ = β - 180° and a telescopic beam path, wherein their respective deflection angles φ are of equal magnitude and their energy-dispersive planes (33, 43) are rotated relative to each other by the angle β.

2. Energy filter according to claim 1, **characterised in that** the transfer lens device (20, 20') is configured such that, in the energy-dispersive plane (33), it projects the intermediate image $ZB_1$ (23) in the exit plane (5) of the first energy analyser (30, 30', 30'') onto the entrance plane (6) of the second energy analyser (40, 40', 40'') as the intermediate

image ZB$_2$ (24) with a linear magnification of $V_L = \dfrac{ZB_2}{ZB_1} < 0$ and with an angular magnification $V_W = \dfrac{\alpha_2}{\alpha_1} < 0$

with $V_W V_L \sqrt{\dfrac{E_2}{E_1}} = 1$ turned by the angle $\gamma$,

wherein $\alpha_1$ denotes the exit angle of the charged particles from the exit plane (5) of the first energy analyser (30, 30', 30"), $\alpha_2$ denotes the entrance angle into the entrance plane (6) of the second energy analyser (40, 40', 40"), $E_1$ denotes the kinetic energy of the charged particles in the exit plane of the first energy analyser (30, 30', 30") and $E_2$ denotes the kinetic energy of the charged particles in the entrance plane of the second energy analyser (40, 40', 40") and

wherein the charged particles pass through a telescopic beam path in the transfer lens device (20, 20').

3. Energy filter according to claim 1 or 2, **characterised in that** the energy analysers (30, 30', 30", 40, 40', 40") and the transfer lens device (20) are arranged point-symmetrically about the centre of the transfer lens device.

4. Energy filter according to claim 1 or 2, **characterised in that** the energy analysers (30, 30', 30", 40, 40', 40") are of different sizes.

5. Energy filter according to any one of claims 1 to 4, **characterised in that** the energy analysers are spherical sectors (30', 40'), hemispherical analysers (30, 40) or cylindrical analysers (30", 40").

6. Energy filter according to claim 5, **characterised in that** the energy-dispersive planes (33, 43) of the hemispherical analysers (30, 40) are arranged rotated by the angle $\beta = 180°$ about the axis (200) of the transfer lens device (20), so that the beam path has an "S" shape.

7. Energy filter according to any one of claims 1 to 6, **characterised in that** the transfer lens device (20) comprises at least one electrostatic tube lens (21, 22).

8. Energy filter according to any one of claims 1 to 7, **characterised in that** the transfer lens device (20') comprises at least one magnetic lens.

9. Energy filter according to any one of claims 1 to 8, **characterised in that** the transfer lens device (20) comprises at least one multipole lens (121, 122).

10. Energy filter according to any one of claims 1 to 9, **characterised in that** the transfer lens device (20) has at least two lenses (21, 21') and (22,22'), and the exit plane (5) of the first energy analyser (30, 30', 30") is disposed in the focal point of the first lens (21, 21') and the entrance plane (6) of the second energy analyser (40, 40', 40") is disposed in the focal point of the second lens (22, 22'), wherein the distance between the two lenses is 2F and F denotes the focal distance of the lenses (21, 22, 21', 22').

11. Use of an energy filter according to any one of claims 1 to 10 for electron microscopy.

12. Use of an energy filter according to any one of claims 1-10 for time-resolved measuring apparatuses.

**Revendications**

1. Filtre à énergie générateur d'image pour des particules chargées électriquement, comme des électrons et des ions, avec au moins deux analyseurs d'énergie toroïdaux disposés l'un derrière l'autre, au moins un analyseur d'énergie présentant un obturateur dans son plan d'entrée et dans son plan de sortie, **caractérisé en ce qu'**entre le plan de sortie (5) du premier analyseur d'énergie (30, 30', 30'') et le plan d'entrée (6) du second analyseur d'énergie (40, 40', 40") est disposé un dispositif de lentilles de transfert (20, 20') qui présente un grossissement latéral $V_L$ négatif et un grossissement d'angle $V_W$ négatif, une rotation d'image de l'angle $\gamma = \beta - 180°$ et une trajectoire de faisceau télescopique, leurs angles de déviation $\phi$ respectifs étant de même grandeur et leurs plans (33, 43) dispersifs en énergie étant tournés de l'angle $\beta$ l'un par rapport à l'autre.

**2.** Filtre à énergie selon la revendication 1, **caractérisé en ce que** le dispositif de lentilles de transfert (20, 20') est conçu de telle sorte qu'il reproduit dans le plan (33) dispersif en énergie l'image intermédiaire $ZB_1$ (23) dans le plan de sortie (5) du second analyseur d'énergie (30, 30', 30'') avec un grossissement linéaire de

$$V_L \ = \ \frac{ZB_2}{ZB_1} \ < \ 0$$

et avec un grossissement d'angle

$$V_W \ = \ \frac{\alpha_2}{\alpha_1} \ < \ 0$$

avec

$$V_W V_L \sqrt{\frac{E_2}{E_1}} \ = \ 1$$

tourné de l'angle $\gamma$ sur le plan d'entrée (6) du second analyseur d'énergie (40, 40', 40") comme image intermédiaire $ZB_2$(24),

dans lequel $\alpha_1$ désigne l'angle de sortie des particules chargées du plan de sortie (5) du premier analyseur d'énergie (30, 30', 30''), $\alpha_2$ désigne l'angle d'entrée dans le plan d'entrée (6) du second analyseur d'énergie (40, 40', 40"), $E_1$ désigne l'énergie cinétique des particules chargées dans le plan de sortie du premier analyseur d'énergie (30, 30', 30") et $E_2$ désigne l'énergie cinétique des particules chargées dans le plan d'entrée du second analyseur d'énergie (40, 40', 40'') et

dans lequel les particules chargées parcourent une trajectoire de faisceau télescopique dans le dispositif de lentilles de transfert (20, 20').

**3.** Filtre à énergie selon la revendication 1 ou 2, **caractérisé en ce que** les analyseurs d'énergie (30, 30', 30", 40, 40', 40") et le dispositif de lentilles de transfert (20) sont disposés avec une symétrie ponctuelle autour du centre du dispositif de lentilles de transfert.

**4.** Filtre à énergie selon la revendication 1 ou 2, **caractérisé en ce que** les analyseurs d'énergie (30, 30', 30", 40, 40', 40") présentent différentes grandeurs de construction.

**5.** Filtre à énergie selon l'une quelconque des revendications 1 à 4, **caractérisé en ce que** les analyseurs d'énergie sont des secteurs sphériques (30', 40'), des analyseurs hémisphériques (30, 40) ou des analyseurs cylindriques (30", 40").

**6.** Filtre à énergie selon la revendication 5, **caractérisé en ce que** les plans (33, 43) dispersifs en énergie des analyseurs hémisphériques (30, 40) sont disposés tournés de l'angle $\beta$ = 180° autour de l'axe (200) du dispositif de lentilles de transfert (20), de sorte que la trajectoire de faisceau présente un contour en forme de S.

**7.** Filtre à énergie selon l'une quelconque des revendications 1 à 6, **caractérisé en ce que** le dispositif de lentilles de transfert (20) comprend au moins une lentille tubulaire (21, 22) électrostatique.

**8.** Filtre à énergie selon l'une quelconque des revendications 1 à 7, **caractérisé en ce que** le dispositif de lentilles de transfert (20') comprend au moins une lentille magnétique.

**9.** Filtre à énergie selon l'une quelconque des revendications 1 à 8, **caractérisé en ce que** le dispositif de lentilles de transfert (20) comprend au moins une lentille multipolaire (121, 122).

**10.** Filtre à énergie selon l'une quelconque des revendications 1 à 9, **caractérisé en ce que** le dispositif de lentilles de transfert (20) présente au moins deux lentilles (21, 21') et (22, 22') et **en ce que** le plan de sortie (5) du premier analyseur d'énergie (30, 30', 30") est disposé au foyer de la première lentille (21, 21') et le plan d'entrée (6) du second analyseur d'énergie (40, 40', 40") au foyer de la seconde lentille (22, 22'), l'espacement des deux lentilles étant 2F, et F désignant la focale des lentilles (21, 22, 21', 22').

**11.** Utilisation d'un filtre à énergie selon l'une quelconque des revendications 1 à 10 pour des microscopes électroniques.

**12.** Utilisation d'un filtre à énergie selon l'une quelconque des revendications 1 à 10 pour des dispositifs de mesure à pouvoir de résolution dans le temps.

Fig.1

Fig.2

Fig.3

FIG 4

FIG 5

Fig.6

Fig.7

EP 1 559 126 B1

Fig.8

EP 1 559 126 B1

Fig.9b

Fig.9a

Fig.10